# EUROPEAN PATENT APPLICATION

(11) **EP 4 783 751 A1**
(43) Date of publication of application: **29.07.2026**
(21) Application number: 26152630.5
(22) Date of filing: 19.01.2026
(51) Int. Cl.: H05K 1/02

(54) **USB CHARGER FOR VEHICLE**

(30) Priority: 22.01.2025 KR 20250009420
(71) Applicant: Unick Corporation, Gimhae-si, Gyeongsangnam-do 50870 (KR)
(72) Inventor: ROH, Eui-Dong, 50870 Gyeongsangnam-do (KR); CHOI, Wook-Hyun, 50870 Gyeongsangnam-do (KR); KIM, Tae-Yong, 50870 Gyeongsangnam-do (KR); HAN, Seung-Min, 50870 Gyeongsangnam-do (KR); YUN, Chan-Gu, 50870 Gyeongsangnam-do (KR); CHOI, Nak-Ju, 50870 Gyeongsangnam-do (KR)
(74) Representative: Zacco Sweden AB

(57) **Abstract**

The present disclosure relates to a USB charger for a vehicle, which more effectively dissipate heat generated during power charging and data transmission, and the USB charger includes a case, a board provided inside the case, and a USB receptacle mounted on the board and exposed to the outside through one surface of the case. A heat dissipation and discharge prevention film is provided on at least a portion of the board, and the heat dissipation and discharge prevention film is in contact with the case, thereby dissipating heat of the board to the outside and inducing a surge introduced into the board to an external ground.

## Description

### TECHNICAL FIELD

The present disclosure relates to a USB charger for a vehicle, and more particularly, to a USB charger for a vehicle, which can more effectively dissipate heat generated during power charging and data transmission.

### BACKGROUND

As the use of information communication devices for vehicles, including navigations, black boxes, Hi-pass terminals, and the like increase, a power outlet is provided in recently produced vehicles to enable power to be stably supplied to the information communication devices.

For example, in small-sized vehicles, the power outlet is installed in the form of a cigar lighter having a power outlet function so as to achieve the efficiency of a mounting space and reduction in cost. In medium-sized vehicles, the power outlet is installed in the form of a power outlet separated from the cigar lighter in center fasciae, console boxes, trunks, and the like.

A USB charger for a vehicle, filed and registered by the present applicant, is disclosed in Korean Laid-Open Patent No. 2023-0003677 (January 6, 2023).

Meanwhile, as requirements for high performance, high speed, and/or multi-function of USB chargers for vehicles increase, the integration and/or number of semiconductor devices increases, and therefore, a technique capable of more effectively dissipating heat generated during power charging and data transmission.

### [RELATED LITERATURES]

### [Patent Literatures]

(Patent Literature 1) Korean Laid-Open Patent Publication No. 2023-0003677 (January 6, 2023)

### SUMMARY

The present disclosure is intended to solve the problems of the prior art described above, and an object is to provide a USB charger for a vehicle, which can more effectively dissipate heat generated during power charging and data transmission.

A USB charger for a vehicle according to the present disclosure for achieving the above object includes a case, a board provided inside the case, and a USB receptacle mounted on the board and exposed to the outside through one surface of the case.

A heat dissipation and discharge prevention film is provided on at least a portion of the board, and the heat dissipation and discharge prevention film is in contact with the case, thereby dissipating heat of the board to the outside and inducing a surge introduced into the board to an external ground

In the present disclosure configured as described above, heat generated in the board during power charging and data transmission can be more effectively dissipated through the heat dissipation and discharge prevention film.

Further, in the present disclosure, a surge introduced into the board is induced to an external ground through the heat dissipation and discharge prevention film, so that a circuit can be safely protected from the surge.

In addition to the above-mentioned effects, the specific effects of the present disclosure as not mentioned will be described below along with the descriptions of the specific details for carrying out the present disclosure.

### BRIEF DESCRIPTION OF THE DRAWINGS

FIG. 1 is front perspective view of a USB charger for a vehicle according to an embodiment of the present disclosure.
FIG. 2 is a rear perspective view of the USB charger according to the embodiment of the present disclosure.
FIG. 3 is an exploded perspective view of the USB charger according to the embodiment of the present disclosure.

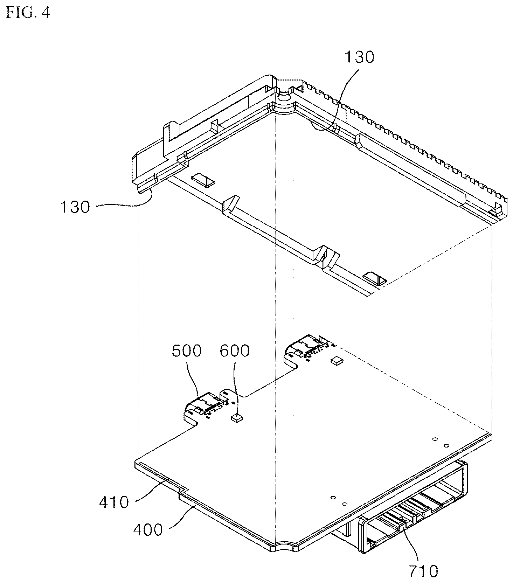

FIG. 4 is a view showing an upper case and a board in the USB charger according to the embodiment of the present disclosure.

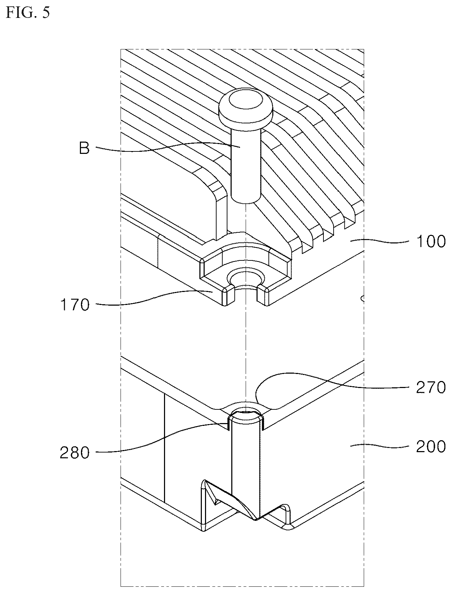

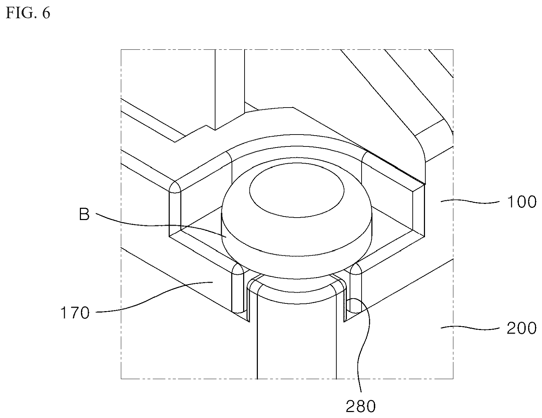

FIGS. 5 and 6 are views showing a fastening structure of the upper case and a lower case in the USB charger according to the embodiment of the present disclosure.

### MODE FOR CARRYING OUT THE DISCLOSURE

The above-described objects, features and advantages will be described below in detail with reference to the accompanying drawings, and accordingly, those of ordinary skill in the art to which the present disclosure pertains will be able to easily implement the technical idea of the present disclosure. In describing the present disclosure, a detailed description of related known technologies will be omitted if it is determined that they unnecessarily make the gist of the present disclosure unclear. Hereinafter, preferred exemplary embodiments of the present disclosure will be described in detail with reference to the accompanying drawings. In the drawings, like reference numerals are used to indicate like or similar components.

Although the terms "first," "second," and the like are used for describing various components, these components are not confined by these terms. These terms are merely used for distinguishing one component from the other components. Therefore, a first component to be mentioned below may be a second component in a technical concept of the present disclosure.

Throughout the specification, unless otherwise described to the contrary, each component may be singular or plural.

Hereinafter, the fact that an arbitrary configuration is disposed at the "upper (or lower)" of the component or "on (or below)" the component may mean that not only that an arbitrary component is disposed in contact with an upper surface (or lower surface) of the component, but also that other components may be interposed between the component and any component disposed on (or below) the component.

In the case that it is described that a certain component is "connected," "coupled" or "joined" to another component, it should be understood that another component may be "connected," "coupled" or "joined" to the component not only directly but also indirectly through an intervening component. Here, other components may be included in one or more of two or more components that are "connected," "coupled" or "connected" to each other.

The singular forms used herein are intended to include the plural forms as well, unless the context clearly indicates otherwise. Terms "comprise" or "include" used herein should not construed as necessarily including all of various components or various steps, but construed that they may not include some of the components or steps or may further include additional components or steps.

Throughout this specification, unless otherwise described to the contrary, "A and/or B" means A, B, or A and B, and unless otherwise described to the contrary, "C to D" means C or more and D or less.

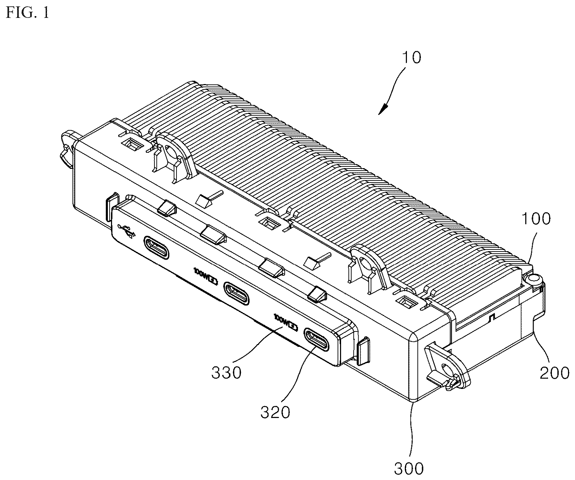

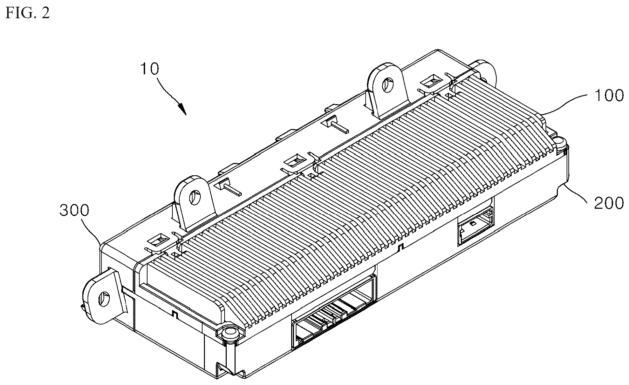

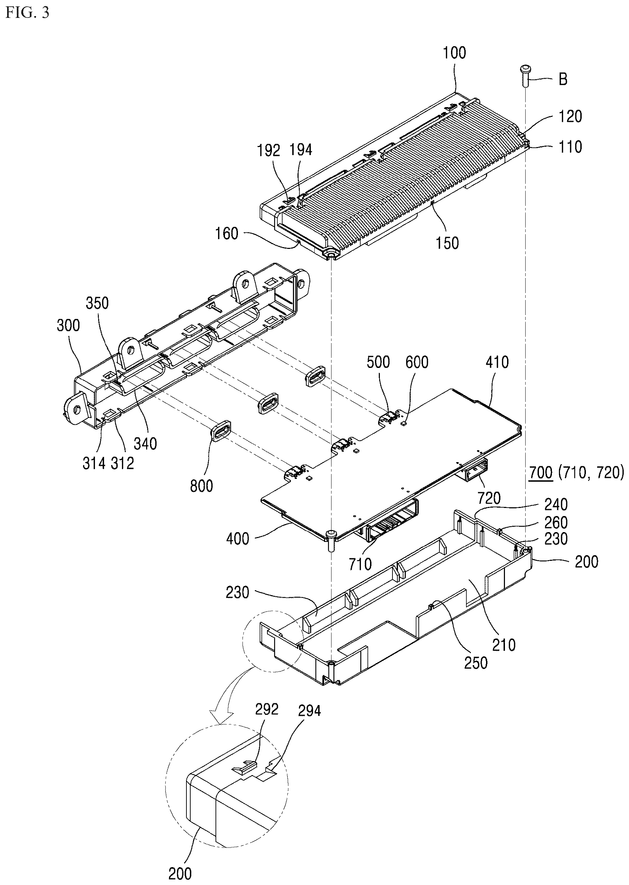

As shown in FIGS. 1 to 3, a USB charger 10 for a vehicle according to an embodiment of the present disclosure includes a case 100 to 300, a board 400 provided inside the case 100 to 300, and a USB receptacle 500, a light source module 600, and a socket 700, which are mounted on the board 400.

The case 100 to 300 is a component that forms an appearance of the USB charger 10 for the vehicle, and has a thin rectangular parallelepiped box shape to be able to be installed in a center fascia (not shown), a console box (not shown), or the like of the vehicle.

The case 100 to 300 includes a case body 100 and 200 and a cover 300 coupled to a front end of the case body 100 and 200.

The case body 100 and 200 is composed of an upper case 100 and a lower case 200, which are separable coupled to each other such that components such as a board 400 installed therein can be replaced.

First, the lower case 200 will be described. The lower case 200 has a half pipe shape with a rectangular section, which is an accommodation space 210 for installation of the board 400 is provided therein.

More specifically, a front end of the lower case 200 is opened such that a portion of a front end of the board 400 installed in the accommodation space 210 can be exposed to the outside, and a rear end of the lower case 200 has a closed half pipe shape.

A holder 230 that supports the board 400 installed in the accommodation space 210 is provided inside the lower case 200. The holder 230 may have the shape of a rib protruding from a wall surface of the lower case 200 or may have the shape of a flange protruding from the bottom of the lower case 200.

A stopping step 240 is formed in each of both side walls of the lower case 200. The stopping step 240 prevents the board 400 installed in the accommodation space 210 from moving in a width direction (front-rear direction on the drawings) of the lower case 200.

Meanwhile, stopping projections 250 and 260 for specifying a coupling position of the lower case 200 to the upper case 100 and preventing movement of the upper case 100 pre-coupled to the lower case 200 are formed in the lower case 200.

The stopping projections 250 and 260 is composed of a first stopping projection 250 formed on a rear wall of the lower case 200 to prevent movement in a length direction (left-right direction) of the upper case 100 and a second stopping projection 260 formed on each of the side walls of the lower case 200 to prevent movement in the width direction (front-rear direction) of the upper case 100.

The above-described lower case 200 may be made of an acrylonitrile butadiene styrene (ABS) material that is strong against impact, has a high strength, is easily moldable when heat is applied, and has excellent heat resistance, chemical resistance, and insulating properties.

The upper case 100 has a plate shape covering the accommodation space 210 in which the board 400 is installed. The upper case 100 is formed in a structure that can dissipate heat generated in the board 400 during power charging and data transmission.

That is, the upper case 100 has a rectangular plate shape corresponding to an open upper surface of the lower case 200, and a heat dissipation structure 110 and 120 is provided on an upper surface of the upper case 100 to be able to effectively dissipate the heat generated in the board 400.

The heat dissipation structure 110 and 120 of this embodiment is composed of a heat dissipation surface 110 arranged to face the board 400 and heat dissipation fins 120 protruding at a certain interval on an outside of the heat dissipation surface 110

Each heat dissipation fin 120 extends long in the width direction (front-rear direction) of the upper case 100 to secure a contact area with ambient air, and a plurality of heat dissipation fins 120 are arranged at a certain interval along the length direction (left-right direction) of the upper case 100.

Although not shown in the drawings, the heat dissipation fin 120 may be formed in a shape having a sectional area decreasing as approaching an end portion thereof. In this case, the contact area with ambient air increases, thereby improving heat dissipation efficiency.

Meanwhile, in the USB charger 10 for the vehicle according to this embodiment, a heat dissipation and discharge prevention film 410 is provided on the board 400 to be able to more effectively dissipate the heat generated in the board 400, and a contact portion 130 in contact with the heat dissipation and discharge prevention film 410 is formed in the upper case 100.

The contact portion 130 extends along a circumference of the upper case 100 and protrudes toward the board 400 from the bottom of the upper case 100, to be in close contact with the heat dissipation and discharge prevention film 410 in coupling of the upper case 100.

As such, when the contact portion 130 of the upper case 100 is in close contact with the heat dissipation and discharge prevention film 410 of the board 400, the heat generated in the board 400 is transferred directly to the heat dissipation surface 110 of the upper case 100, and thus the heat dissipation efficiency can be further improved.

Meanwhile, a first stopping groove 150 corresponding to the first stopping projection 250 of the lower case 200 and a second stopping groove 160 corresponding to the second stopping groove 260 of the lower case 200 are formed in the upper case 100.

As described above, the first stopping groove 150 prevents movement in the length direction (left-right direction) of the upper case 100 pre-coupled to the lower case 200, and the second stopping groove 160 prevents movement in the width direction (front-rear direction) of the upper case 100 pre-coupled to the lower case 200.

Unlike the above-described lower case 200, the upper case 100 is preferably made of a conductor material to be able to effectively dissipate the heat generated in the board 400.

For example, the upper case 100 may be made of thermal conductive plastic that has excellent thermal conductivity while reducing electric conductivity and is easily moldable by adding a thermal conductive filler such as aluminum, copper, carbon fiber, or ceramic.

As shown in the drawings, the upper case 100 and the lower case 200 are coupled to each other by a fastening bolt B.

To this end, a fastening portion 170 through which the fastening bolt B passes is provided in the upper case 100, and a coupling portion 270 to which the fastening bolt B is screw-coupled is formed in the lower case 200.

The fastening portion 170 has a C-shape with one open side, and this is for the purposed of preventing a corner of the fastening portion as a strength weakness portion from being damaged by the fastening bolt B in a process of combining the case body 100 and 200.

In other words, the upper case 100 made of the thermal conductive plastic, to which the thermal conductive filler is added, has a weak strength as compared with the lower case 200, and thus damage caused by stress concentration can be prevented when the one side of the fastening portion 170 is opened.

A stopper 280 inserted into the one open side of the fastening portion 170 protrudes at one side of the coupling portion 270. The stopper 280 functions to specify a coupling position of the upper case 100 and the lower case 200, and protrudes downwardly of the fastening portion 170 such that the upper case 100 and the lower case 200 can be adhered closely to each other.

Meanwhile, locking projections 192 and 292 for coupling to the cover 300 are formed at front end circumferences of the case body 100 and 200 composed of the upper case 100 and the lower case 200, respectively, and rework grooves 194 and 294 for separation of the cover 300 are formed at peripheries of the locking projections 192 and 292, respectively.

The cover 300 has a pipe shape with a rectangular section, which covers the open front end of the case body 100 and 200, more specifically, a pipe shape with a closed front end and an open rear end.

A locking tab 312 for coupling to the case body 100 and 200 is formed at a circumference of the cover 300, and a locking hole 314 into which each of the locking projections192 and 292 is inserted is formed in the locking tab 312.

A connection hole 320 into which the USB receptacle 500 is inserted is formed in a front surface of the cover 300, and a display unit 330 that displays a charging state is formed at one side of the connection hole 320.

The USB receptacle 500 may be exposed to the outside through the connection hole 320 to be connected to a USB plug (not shown), and the charging state may be checked through the display unit 330 in the connection of the USB plug (not shown).

A reflector 340 that focuses light generated in the light source module 600 to be able to be irradiated to the outside through the connection hole 320 and the display unit 330 is provided inside the cover 300.

The reflector 340 has a pipe shape surrounding the front end of the board 400 on which the light source module 600 is mounted, more specifically, a pipe shape extending from a front end rear surface of the cover 400 so as to focus the light generated in the light source module 600.

The reflector 340 has a pipe shape with a rectangular section, and a slit 350 for insertion of the board 400 is formed in each of both sides thereof. The slit 350 is formed in a shape broadened as approaching a rear end thereof to be able to guide the insertion of the board 400.

The board 400 is a means for power supply and data transmission, and may be a printed circuit board (PCB) having a conductor circuit formed on a surface thereof.

As described above, the heat dissipation and discharge prevention film 410 for dissipating heat generated during power charging and data transmission is provided on the board 400. The heat dissipation and discharge prevention film 410 is formed along a circumference of an upper surface of the board 400, and is in contact with the contact portion 130 of the upper case 100. The heat dissipation and discharge prevention film 410 is preferably a copper laminated film to be able to effectively dissipate heat of the board 400.

Meanwhile, the heat dissipation and discharge prevention film 410 may function to induce a surge introduced into the board 400 to an external ground in addition to the function of dissipating the heat of the board 400. In this case, the heat dissipation and discharge prevention film 410 can safely protect a circuit from the surge.

The USB receptacle 500 for connection to an external device, the light source module 600 for generating light during power application and data transmission, and the socket 700 for power supply and data transmission are mounted on the board 400.

The USB receptacle 500 is a connector for connection to an external device. Although a C-type USB receptacle is exemplified in this embodiment, the present disclosure is not necessarily limited thereto.

In addition, the light source module 600 is a means that displays charging and data transmission states by generating light when the USB plug (not shown) is connected to the USB receptacle 500, and an LED module is used in this embodiment.

The socket 700 is a connector for power supply and data transmission, and a socket 710 for power supply and a socket 720 for data transmission are separately provided in this embodiment.

Meanwhile, a prism 800 is installed at front end circumference of the board 400 on which the light source module 600 is mounted. The prism 800 spreads light generated in the light source module 600 and light reflected by the reflector 340, thereby improving visibility.

In the USB charger 10 for the vehicle according to this embodiment configured as described above, heat generated in the board 400 during power charging and data transmission can be more effectively dissipated through the heat dissipation and discharge prevention film 410 provided on the board 400.

Particularly, although not shown in the drawings, when a heat dissipation pad (not shown) is added between the upper case 100 and the board 400, heat generated in the board 400 can be transferred directly to the heat dissipation surface 110 of the upper case 100, so that more effective heat dissipation is possible.

As described above, the present disclosure is described with reference to the exemplified drawing, but the present disclosure is not limited by the exemplary embodiments and drawings disclosed in this specification, and it is apparent that that various modifications can be made by those skilled in the art without the scope of the technical spirit of the present disclosure. In addition, it is natural that even though an action effect according to the configuration of the present disclosure is explicitly disclosed and described while describing the exemplary embodiments of the present disclosure, predictable effects should also be accepted by the corresponding configuration.

## Claims

1. A USB charger for a vehicle, comprising:
a case;
a board provided inside the case; and
a USB receptacle mounted on the board and exposed to the outside through one surface of the case,
wherein a heat dissipation and discharge prevention film is provided on at least a portion of the board, and the heat dissipation and discharge prevention film is in contact with the case, thereby dissipating heat of the board to the outside and inducing a surge introduced into the board to an external ground.

2. The USB charger of claim 1, wherein the heat dissipation and discharge prevention film is formed along a circumference of at least one surface of the board.

3. The USB charger of claim 2, wherein the heat dissipation and discharge prevention film is a copper laminated film.

4. The USB charger of any one of claims 1 to 3, wherein the case includes an upper case, a lower case, and a cover, and
wherein a contact portion in contact with the heat dissipation and discharge prevention film is formed at a circumference of the upper case.

5. The USB charger of claim 4, wherein heat dissipation fins that dissipate heat transferred through the heat dissipation and discharge prevention film to the outside are formed on the upper case.

6. The USB charger of claim 5, wherein the upper case is made of a conductor material including a thermal conductive plastic.

7. The USB charger of claim 4, wherein the upper case and the lower case are coupled to each other by a fastening bolt, a fastening portion through which the fastening bolt passes is provided in the upper case, and a coupling portion to which the fastening bolt is screw-coupled is formed in the lower case.

8. The USB charger of claim 7, wherein the fastening portion has a C-shape with one open side, and
wherein a stopper inserted into the one open side of the fastening portion protrudes at one side of the coupling portion.

9. The USB charger of claim 8, wherein the stopper protrudes downwardly of the fastening portion.

10. The USB charger of claim 4, wherein a stopping projection that prevents movement of the case is formed in any one of the upper case and the lower case, and a stopping groove corresponding to the stopping projection is formed in the other of the upper case and the lower case.

11. The USB charger of claim 10, wherein the stopping projection and the stopping groove include a first stopping projection and a first stopping groove, which prevent movement in the length direction of the upper case and the lower case, and a second stopping projection and a second stopping groove, which prevent movement in a width direction of the upper case and the lower case, respectively.

12. The USB charger of claim 4, wherein a locking projection for coupling to the cover is formed in at least one of the upper case and the lower case, and a locking tab fixedly locked to the locking projection is formed in the cover.
